# EUROPEAN PATENT SPECIFICATION

(11) **EP 0 599 372 B1**
(45) Date of publication and mention of the grant of the patent: **09.04.1997**
(21) Application number: 93203148.7
(22) Date of filing: 11.11.1993
(51) Int. Cl.: H03L 7/089, H03D 13/00

(54) **PLL with stable phase discriminator**
PLL-Schaltung mit einem stabilen Phasendiskriminator
PLL comportant un discriminateur de phase stable

(30) Priority: 18.11.1992 EP 92203549
(43) Date of publication of application: 01.06.1994
(73) Proprietor: Philips Electronics N.V., 5621 BA Eindhoven (NL); FASELEC A.G., CH-8045 Zürich (CH)
(72) Inventor: Folmer, Lambert Johan Hendrik, NL-5656 AA Eindhoven (NL)
(74) Representative: Strijland, Wilfred

(56) References cited:
- DE-A- 3 813 550
- US-A- 4 105 947
- US-A- 5 124 594
- PATENT ABSTRACTS OF JAPAN vol. 14, no. 166 (E-0911)30 March 1990 & JP-A-02 021 724 (HITACHI LTD.) 24 January 1990

## Description

### FIELD OF THE INVENTION

The invention relates to an electronic circuit with a PLL (phase-locked-loop) comprising a VCO (voltage-controlled-oscillator), a charge pump and a phase discriminator. The VCO has an oscillator output for supplying an oscillator output signal and a control input for control of the VCO. The charge pump has a current source and a current sink and provides a control signal to the control input. The phase discriminator has a first detector input to receive the oscillator output signal and a second detector input to receive a reference signal. The phase discriminator controls the charge pump in dependence on a phase difference between the oscillator output signal and the reference signal. The phase discriminator includes resettable latch means that is responsive to the oscillator output signal and the reference signal to supply a source signal for control of the current source and a sink signal for control of the current sink. The phase discriminator further includes reset means to generate a reset signal for resetting the latch means upon both the current sink and the current source being kept turned on for a particular time span. The generation of the reset signal involves the sink signal and the source signal.

### BACKGROUND ART

PLLs are widely used for, e.g., synchronizing an oscillator, typically a voltage-controlled oscillator (VCO), on a reference frequency, building a synthesizer to produce a plurality of signals with stable frequencies out of a reference signal with a highly stable reference, building active filters, detecting FM signals, etc.

The control signal provided by a typical digital phase discriminator, used to control a VCO, has one polarity in case a phase lag is detected and the other polarity when a phase lead is detected. For very small phase differences, in the transition from one polarity to the other polarity, there is often a dead zone region where the control signal is insensitive to phase-difference changes. However, it is highly important that the control characteristic of the PLL be linear in a phase-difference interval that contains the zero-phase-error working point to avoid the VCO uncontrollably changing its phase. The VCO's undesired phase change gives rise to the so-called dead band range wherein the VCO's eventual output signal is unpredictable and is liable to dither. Such a dead zone region may stem from, for instance, a delay between the charge pump's current source being turned on and the charge pump's current sink being turned off and vice versa.

Prior art document U.S. Patent 4,814,726 discloses a digital PLL of the kind introduced above. In order to ensure that there is no appreciable dead band range in the prior art, both the pump's current sink and current source are kept active in the vicinity of the zero-phase-difference working point without producing a net charge variation at the pump's output. The result is an operation substantially linearly sensitive to a wide range of phase-difference values.

The known PLL comprises first and second latches. At each phase-comparison operation, the first latch stores the reference signal value and supplies the source signal for the current source, and the second latch stores the VCO's signal, after frequency division, to provide the sink signal. Both signals are kept alive for a predetermined delay by using a first logic gate that has first and second inputs coupled to the current source and the current sink, respectively. The first logic gate senses whether or not the current sink and the current source are both turned on. The first logic gate has an output connected to an input of a second logic gate that has two other inputs, one connected to the first latch and the other to the second latch. The second logic gate produces a reset signal, determined by the logic values stored in the latches and delivered by the first logic gate, to reset the latches for the next phase comparison operation. The length of the reset delay is determined by the delays of the logic gates and the pump's elements.

In the prior art device, the characteristics of the charge pump's components and of the logic gates in the reset path determine the moment of resetting the phase discriminator. This still introduces dependencies on process parameters, design features and temperature, adversely affecting stability.

### OBJECT OF THE INVENTION

It is therefore an object of the invention to provide an electronic device as specified in the preamble, whose dependence on process parameter spread, design features and temperature is reduced and which is more accurately controllable than the prior art device.

### SUMMARY OF THE INVENTION

To this end, the invention provides an electronic circuit of the kind specified in the preamble, characterized in that the reset means is connected for receiving the sink signal and the source signal and an enable signal representative of the reference signal and is not connected for receiving the oscillator output signal, said reset means being thereby operative to produce the reset signal under direct control of the sink signal and the source signal and the signal representative of the reference signal and not under direct control of the oscillator output signal.

Both current sink and current source are kept temporarily alive to avoid a dead zone region. The reset signal is produced under combined control of the sink and source control signals and, in addition, of the reference signal to enhance stability. The invention is based on the insight that the reference signal usually is a highly stable signal against which the other signals are measured, thus providing a well defined time frame, possibly after appropriate frequency division of one or both said signals, for example, when the reference signal is supplied by a crystal oscillator. Therefore, the time period between two successive edges of the same or the opposite polarity in the reference signal provides a favourable base to control the resetting of the latch means. If the two edges are a pair of successive upgoing or downgoing edges, the reset is delayed for at the most one cycle of the reference signal. If the two edges are two successive transitions in the reference signal, the effect is a maximum delay of half a cycle. The latter option has the advantage that less noise is generated and accumulated at the pump's output, and that power consumption, due to both the sink and the source being turned on, is reduced.

Note that the operation of the circuit of the invention can be tested more easily than the prior art circuit, since the reset means functions independently of the charge pump.

In an embodiment of the invention, the phase discriminator comprises a logic gate and first and second resettable D-flipflops; each with a clock input, a data input, a reset input and an output. The data inputs of the D-flipflops are connected to a node for receiving a. dc. voltage, e.g., the supply voltage Vcc. The clock input of the first D-flipflop receives the reference signal, and the clock input of the second D-flipflop receives the oscillator output signal. The output of the first D-flipflop provides a signal to activate one of the current source and current sink, whereas the output of the second D-flipflop provides a signal to activate the other one of the current source and current sink. The logic gate has a first gate input coupled to the output of the first D-flipflop, a second gate input coupled to the output of the second D-flipflop, and a third gate input to receive a further signal representative of the reference signal. A gate output of the logic gate is connected to the reset input of both the first and second D-flipflops.

This embodiment is highly simplified with respect to the one of the prior art. Fewer components are needed, resulting in a reduced accumulation of noise effects within the PLL. The reference signal, typically derived from a stable source such as a crystal oscillator, ensures highly accurate operation independent of operational parameters of a dedicated feed-back loop as in the prior art.

### BRIEF DESCRIPTION OF THE DRAWING

The invention is explained below by way of example and with reference to the accompanying drawing, wherein:
Figure 1 shows a block diagram of a typical PLL;
Figure 2 shows a block diagram of a phase discriminator in accordance with the invention;
Figure 3 gives signal diagrams to clarify the operation of the discriminator in Figure 2.

### DETAILED DESCRIPTION OF THE EMBODIMENTS

### General PLL

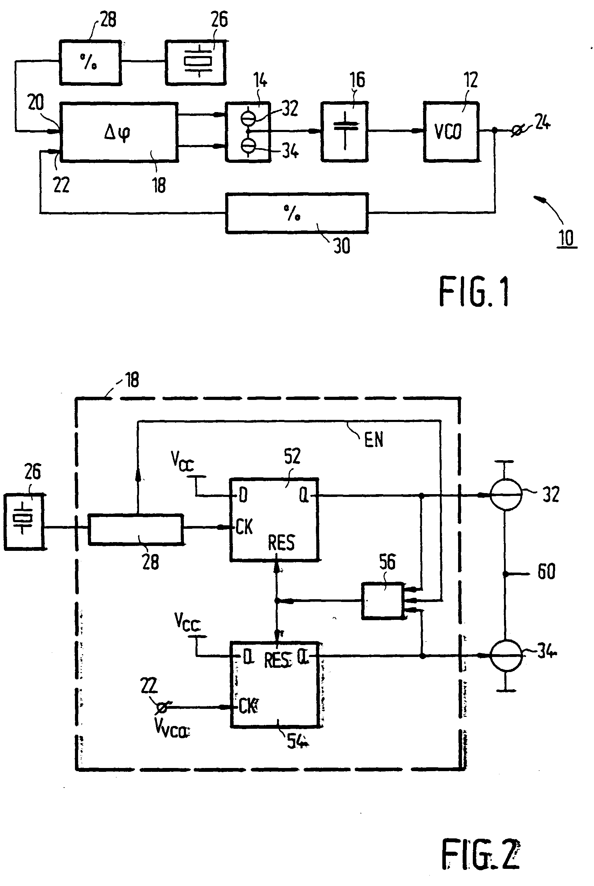

Figure 1 gives a block diagram of a typical PLL 10. PLL 10 comprises a VCO 12 whose oscillation frequency is controlled through a charge pump 14 via a filter 16. Filter 16 substantially is a capacitance to be charged or discharged to supply the control voltage to a control input of VCO 12. Charge pump 14 in turn is controlled by a phase discriminator 18 that mutually correlates a reference signal at an input 20 and a further signal at an input 22 that is indicative of an output signal of VCO 12 at an output 24. The reference signal is derived from a stable oscillator 26, such as a crystal oscillator, either directly or via a divider 28. The further signal may be the VCO's output signal at output 24 or may be derived from the VCO's output signal via a divider 30.

As known, PLL 10 serves to keep the frequency of the signal supplied to input 22 substantially identical to the frequency of the reference signal at input 20. Charge pump 14 basically comprises a current source 32 and a current sink 34. The appropriate control voltage to VCO 12 at the capacitance in filter 16 is produced under control of current source 32 and current sink 34, that in turn are supervised by phase discriminator 18.

As already mentioned above, in order to have PLL 10 operate properly, phase discriminator 18 and pump 14 should collaborate to avoid the dead band around zero-phase error due to non-linearities in the response. This is accomplished by keeping both source 32 and sink 34 turned on in the zero-difference region, without producing a net charge increase or decrease at the pump's output.

### Phase discriminator

Figure 2 shows a phase discriminator 18 according to the invention. Phase discriminator 18 comprises first and second resettable D-flipflops, 52 and 54, each with a clock input CK, a data input D, a reset input RES and an output Q. Discriminator 18 further comprises a logic AND gate 56. D-flipflops are set by a positive edge of the signal supplied to their clock inputs CK, and are reset by a positive level at their reset inputs RES. Data inputs Q of D-flipflops 52 and 54 are connected to a supply voltage Vcc. Clock inputs CK of first D-flipflop 52 receives the reference signal CK52, indicative of the signal provided by crystal oscillator 26, and clock input CK of second D-flipflop 54 receives a signal CK54, indicative of the output signal of VCO 12. Output Q of first D-flipflop 52 provides a source signal to activate current source 32, whereas output Q of second D-flipflop 54 provides a sink signal to activate current sink 34. AND gate 56 has a first gate input coupled to output Q of first D-flipflop 52, a second gate input coupled to output Q of second D-flipflop 54, and a third gate input to divider 28 to receive a further signal representative of reference signal CK52. A gate output of AND gate 56 is connected to reset inputs RES of both first and second D-flipflops 52 and 54.

### Signal diagrams

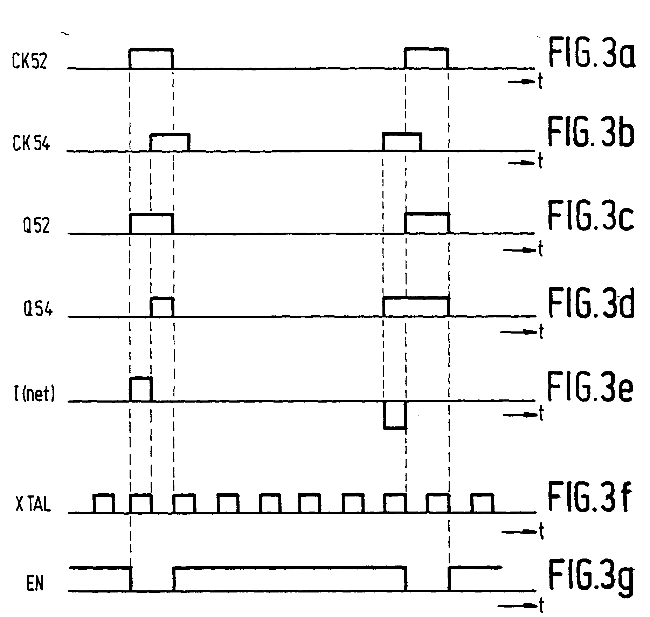

Figures 3a-3g clarify the operation of discriminator 18 in Figure 2 for a first example. Figure 3a shows signal CK52 as a function of time t, and Figure 3b shows signal CK54 as a function of time t. When a positive edge occurs in CK52, D-flipflop 52 is set and produces Q52 being a logic high as shown in Figure 3c. Similarly, when a positive edge occurs in CK54, D-flipflop 54 is set and produces Q54 being a logic high as shown in Figure 3d. Accordingly, when Q52 goes high current source 32 is turned on to supply a current to a pump output 60, and when Q54 goes high current sink 54 is turned on to drain current from pump output 60. The net current I(net) to, and eventual accumulated net charge at, output 60 is proportional to the time interval between the current source and sink being turned on, which is proportional to the phase difference between signals CK52 and CK54. The net current I(net) is shown in Figure 3e as a function of time t.

As explained above, source 32 and sink 34 both have to be kept turned on and then turned off in a well controlled manner when PLL 10 operates in the near zero-phase-difference region. To this end, a stable control signal is generated to properly reset D-flipflops 52 and 54 through AND gate 56 when both source 32 and sink 34 have been turned on. In order to activate AND gate 56 when both Q52 and Q54 are already high, there is needed a third input signal EN that goes high and is well defined regarding its temporal characteristics. Such a signal is available either directly from crystal oscillator 26, or indirectly via divider 28 or an other intermediate circuit.

Figure 3f gives the signal XTAL supplied by crystal oscillator 26. Note that signal CK52 is derived from signal XTAL, for instance, by counting fixed numbers of pulses of signal XTAL before a next transition in CK52. Accordingly, the pulses from crystal oscillator 26 provide a highly accurate time base that easily can be adapted to the task envisaged. For example, the same pulses in signal XTAL can be used to generate the third signal EN having opposite polarity. This is shown in Figure 3g. The associated signal evolution for Q52 and Q54 is shown in Figures 3c and 3d.

The example of Figure 3g is based on a single cycle of signal XTAL whose successive positive edges determine successive transitions in signal EN. Another example could be based on creating a third signal EN based on half a cycle of signal XTAL. This decreases the time during which both sink 34 and source 32 are turned on, since the time during which EN is high is reduced, leading to less noise accumulation at pump output 60 and reduced power dissipation in pump 14. Such a signal EN is derived by means of a simple buffer, e.g. an inverter.

In the examples shown, source 32 is active during a fixed time period, whereas sink 34 is active during a time span depending on the phase difference.

Current peaks in dividers 28 and 30 during normal operation may cause supply voltage modulation and therefore in the temporal behaviour of the switching of source 32 and sink 34. When the signals that control source 32 and sink 34 are modulated in the same way by deriving control signals that are synchronous to the divider operation as in the invention, the modulation effect is reduced. Also, by reducing the action of dividers (or counters) 28 and 30 during signal transmission to charge pump 14 undesired modulation is reduced. This may be accomplished by letting the positive edges of the input signals to dividers 28 and 30 control divider operation and the negative edges of the input signals to dividers 28 and 30 control the phase discriminator.

The above procedure for clock control uses the edges of opposite polarity in the clock signal to control the operation of different circuits on the same chip. This procedure may very well be applied to more general circuitry than to the PLL environment discussed above. It represents an elegant manner to establish a temporal separation of activities to reduce noise generation. Temporal activity distribution may be based on avoiding excessive noise on a clock edge of one polarity by transferring some of the activities to the preceding or succeeding clock edge of the other polarity.

## Claims

1. An electronic circuit with a PLL comprising:
- a VCO (12) having an oscillator output (24) for supplying an oscillator output signal and having a control input for control of the VCO (12);
- a charge pump (14) having a current source (32) and a current sink (34) and being operative to provide a control signal to the control input;
- a phase discriminator (18) having a first detector input (22) to receive the oscillator output signal and a second detector input (20) to receive a reference signal, the phase discriminator (18) being operative to control the charge pump (14) in dependence on a phase difference between the oscillator output signal and the reference signal, the phase discriminator (18) including:
- resettable latch means (52, 54) being responsive to the oscillator output signal and the reference signal and having a first latch output to supply a source signal for control of the current source (32) and a second latch output to supply a sink signal for control of the current sink (34), and a reset input (RES) to receive a reset signal;
- reset means (56) being operative to generate the reset signal for resetting the latch means (52,54) upon both the current sink (34) and the current source (32) being kept turned on for a particular time span, the generation of the reset signal involving the sink signal and the source signal;
characterized, in that the reset means (56) is connected for receiving the sink signal and the source signal and an enable signal (EN) representative of the reference signal and is not connected for receiving the oscillator output signal, said reset means (56) being thereby operative to produce the reset signal under direct control of the sink signal and the source signal and the signal representative of the reference signal and not under direct control of the oscillator output signal.

2. The circuit of claim 1, wherein the reset means (56) comprises:
- a reset logic gate (56) having an output coupled to the reset input of the latch means (52, 54) for providing the reset signal, and having first and second inputs coupled to the first and second latch outputs for being controlled via the source signal and the sink signal, and having a third input to receive the enable signal representative of the reference signal.

3. The circuit of Claim 2, wherein the enable signal is derived from the reference signal through a counter or a divider (28).

4. The circuit of Claim 2, wherein the enable signal is derived from two successive edges of a same polarity in the reference signal.

5. The circuit of Claim 2, wherein the enable signal is derived from two successive edges of opposite polarity in the reference signal.

6. The circuit of Claim 2, 3, 4 or 5, wherein the latch means (52, 54) comprises:
- a first D-flipflop (52) having a clock input controlled by the reference signal, a D-input to receive a dc voltage, a reset input (RES) to receive the reset signal from the reset logic gate (56), and a Q-output connected to the first input of the reset logic gate (56) and providing one of the source signal and the sink signal;
- a second D-flipflop (54) having a clock input controlled by the oscillator (12) output signal, a D-input to receive the dc voltage, a reset input to receive the reset signal from the reset logic gate (56), and a Q-output connected to the second input of the reset logic gate and providing the other of the source signal and the sink signal.

## Patentansprüche

1. Elektronikschaltung mit einer PLL (Phasenverriegelungsschleife) mit einem VCO (spannungsgeregelten Oszillator) (12) einer Ladungspumpe mit einem Oszillatorausgang (24) zum Erzeugen eines Oszillatorausgangssignals und einem Steuereingang zur Steuerung des VCO (12), einer Ladungspumpe (14) mit einer Stromquelle (32) sowie einer Stromsenke (34) und betriebsfähig zum Erzeugen eines Steuersignals am Steuereingang, einem Phasendiskriminator (18) mit einem ersten Detektoreingang (22) zum Empfangen des Oszillatorausgangssignals und einem zweiten Detektoreingang (20) zum Empfangen eines Bezugssignals, wobei der Phasendiskriminator (18) zum Steuern der Ladungspumpe (14) abhängig von einem Phasenunterschied zwischen dem Oszillatorausgangssignal und dem Bezugssignal betreibbar ist, und folgende Elemente enthält:
ein rückstellbares Verriegelmittel (52, 54), das auf das Oszillatorausgangssignal und das Bezugssignal anspricht und einen ersten Verriegelausgang zur Erzeugung eines Quellensignals zur Steuerung der Stromquelle (32) sowie einen zweiten Verriegelausgang zur Erzeugung eines Senkensignals zur Steuerung der Stromsenke (34) enthält, und der Phasendiskriminator außerdem einen Rückstelleingang (RES) zum Erzeugen eines Rückstellsignals,
ein Rückstellmittel (56), das zum Erzeugen des Rückstellsignals zum Rückstellen des Verriegelmittels (52, 54) enthält, wenn sowohl die Stromsenke (34) als auch die Stromquelle (32) für die Dauer einer besonderen Zeitspanne eingeschaltet bleiben,
wobei die Erzeugung des Rückstellsignals sich auf das Senkensignal und auf das Quellensignal bezieht, dadurch gekennzeichnet, daß das Rückstellmittel (56) zum Empfangen des Senkensignals und des Quellensignals und eines Freigabesignals (EN) zur Darstellung des Bezugssignals angeschlossen und nicht zum Empfangen des Oszillatorausgangssignals angeschlossen ist, wobei das Rückstellmittel (56) zum Erzeugen des Rückstellsignals unter direkter Steuerung des Senkensignals und des Quellensignals und der Signaldarstellung des Bezugssignals und nicht unter direkter Steuerung des Oszillatorausgangssignals im Betrieb ist.

2. Schaltung nach Anspruch 1, worin das Rückstellmittel (56) ein logisches Rückstellgatter (56) mit einem Ausgang, der mit dem Rückstelleingang des Verriegelmittels (52, 54) zum Erzeugen des Rückstellsignals gekoppelt ist, und mit ersten und zweiten Eingängen, die mit den ersten und zweiten Verriegelausgängen zu ihrer Steuerung mittels des Quellensignals und des Senkensignals gekoppelt ist, und mit einem dritten Eingang zum Empfangen des Freigabesignals zur Darstellung des Bezugssignals enthält.

3. Schaltung nach Anspruch 2, worin das Freigabesignal über einen Zähler oder einen Teiler (28) vom Bezugssignal abgeleitet ist.

4. Schaltung nach Anspruch 2, worin das Freigabesignal von zwei aufeinanderfolgenden Flanken mit derselben Polarität im Bezugssignal abgeleitet ist.

5. Schaltung nach Anspruch 2, worin das Freigabesignal von zwei aufeinanderfolgenden Flanken entgegengesetzter Polarität im Bezugssignal abgeleitet ist.

6. Schaltung nach Anspruch 2, 3, 4 oder 5, worin das Verriegelmittel (52, 54) ein erstes D-Flipflop (52) mit einem vom Bezugssignal gesteuerten Takteingang, einen D-Eingang zum Empfangen einer Gleichspannung, einen Rückstelleingang (RES) zum Empfangen des Rückstellsignals aus dem logische Rückstellgatter (56) sowie einen mit dem ersten Eingang des logische Rückstellgatters (56) verbundenen Q-Ausgang, der das Quellensignal oder das Senkensignal liefert, und ein zweites D-Flipflop (54) mit einem vom Ausgangssignal des Oszillators (12) gesteuerten Takteingang, einem D-Eingang zum Empfangen der Gleichspannung, einem Rückstelleingang zum Empfangen des Rückstellsignals aus dem logischen Rückstellgatter (56) sowie einem mit dem zweiten Eingang des logischen Rückstellgatters verbundenen Q-Ausgang enthält, der das andere des Quellensignals oder des Senkensignals liefert.

## Revendications

1. Circuit électronique pourvu d'une PLL comprenant :
- un VCO (12) ayant une sortie (24) pour délivrer un signal de sortie d'oscillateur et une entrée de commande pour commander le VCO (12);
- une pompe à charge (14) ayant une source de courant (32) et un récepteur de courant (34) et qui est à même de délivrer un signal de commande à l'entrée de commande;
- un discriminateur de phase (18) ayant une première entrée de détecteur (22) pour recevoir le signal de sortie de l'oscillateur et une deuxième entrée de détecteur (20) pour recevoir un signal de référence, le discriminateur de phase (18) étant à même de commander la pompe à charge (14) en fonction d'une différence de phase entre le signal de sortie de l'oscillateur et le signal de référence, le discriminateur de phase (18) comprenant :
- des moyens de verrouillage (52, 54) pouvant être remis à zéro qui sont sensibles au signal de sortie de l'oscillateur et au signal de référence et ont une première sortie pour délivrer un signal de source pour commander la source de courant (32) et une deuxième sortie pour délivrer un signal de récepteur pour commander le récepteur de courant (34), et une entrée de remise à zéro (RES) pour recevoir un signal de remise à zéro;
- des moyens de remise à zéro (56) qui sont à même de générer le signal de remise à zéro pour remettre à zéro les moyens de verrouillage (52, 54) lorsque, à la fois, le récepteur de courant (34) et la source de courant (32) sont maintenus conducteurs pendant une période de temps particulière, la génération du signal de remise à zéro impliquant le signal de récepteur et le signal de source,
caractérisé en ce que les moyens de remise à zéro (56) sont connectés pour recevoir le signal de récepteur et le signal de source et un signal de validation (EN) représentatif du signal de référence et ne sont pas connectés pour recevoir le signal de sortie de l'oscillateur, lesdits moyens de remise à zéro (56) étant ainsi opérationnels pour produire le signal de remise à zéro sous le contrôle direct du signal de récepteur et du signal de source ainsi que du signal représentatif du signal de référence et non sous le contrôle direct du signal de sortie de l'oscillateur.

2. Circuit selon la revendication 1, dans lequel les moyens de remise à zéro (56) comprennent :
- une porte logique de remise à zéro (56) ayant une sortie couplée à l'entrée de remise à zéro des moyens de verrouillage (52, 54) pour délivrer le signal de remise à zéro et ayant une première et une deuxième entrées couplées à la première et à la deuxième sorties des verrous pour être contrôlée via le signal de source et le signal de récepteur et ayant une troisième entrée pour recevoir le signal de validation représentatif du signal de référence.

3. Circuit selon la revendication 2, dans lequel le signal de validation est tiré du signal de référence via un compteur ou un diviseur (28).

4. Circuit selon la revendication 2, dans lequel le signal de validation est tiré de deux flancs successifs de même polarité du signal de référence.

5. Circuit selon la revendication 2, dans lequel le signal de validation est tiré de deux flancs successifs de polarités opposées du signal de référence.

6. Circuit selon la revendication 2, 3, 4 ou 5, dans lequel les moyens de verrouillage (52, 54) comprennent :
- une première bascule D (52) ayant une entrée d'horloge commandée par le signal de référence, une entrée D pour recevoir une tension continue, une entrée de remise à zéro (RES) pour recevoir le signal de remise à zéro de la porte logique de remise à zéro (56) et une sortie Q connectée à la première entrée de la porte logique de remise à zéro (56) et délivrant l'un des signaux de source et de récepteur;
- une deuxième bascule D (54) ayant une entrée d'horloge commandée par le signal de sortie de l'oscillateur (12), une entrée D pour recevoir la tension continue, une entrée de remise à zéro pour recevoir le signal de remise à zéro de la porte logique de remise à zéro (56) et une sortie Q connectée à la deuxième entrée de la porte logique de remise à zéro et délivrant l'autre des signaux de source et de récepteur.
